# EUROPÄISCHE PATENTSCHRIFT

(11) **EP 3 190 700 B1**
(45) Veröffentlichungstag und Bekanntmachung des Hinweises auf die Patenterteilung: **07.10.2020**
(21) Anmeldenummer: 16184883.3
(22) Anmeldetag: 19.08.2016
(51) Int. Cl.: H03G 3/30, H03G 7/00

(54) **VERFAHREN UND VORRICHTUNG ZUR VERARBEITUNG VON AUDIO-SIGNALEN**
METHOD AND DEVICE FOR PROCESSING AUDIO SIGNALS
PROCÉDÉ ET DISPOSITIF DESTINÉS AU TRAITEMENT DE SIGNAUX AUDIO

(30) Priorität: 15.09.2015 DE 102015217565
(43) Veröffentlichungstag der Anmeldung: 12.07.2017
(73) Patentinhaber: Ford Global Technologies, LLC, Dearborn, MI 48126 (US)
(72) Erfinder: Jacobs, Björn, 53881 Euskirchen (DE); Bellof, Marco, 52070 Aachen (DE)
(74) Vertreter: Dörfler, Thomas

(56) Entgegenhaltungen:
- US-A1- 2009 271 185

## Beschreibung

Die Erfindung betrifft ein Verfahren und eine Vorrichtung zur Verarbeitung von Audio-Signalen in einem Entertainment-System.

Heutzutage verwenden Entertainment-Systeme eine Vielfalt unterschiedlicher Audioquellen. Hierbei weist typischerweise jede Audioquelle einen spezifischen Lautstärkepegel auf, welcher durch die jeweilige Hardware, die verwendete Software sowie die betreffende Audiospur (Audio-Track) vorgegeben wird. Nach Änderung der Audioquelle ist der Nutzer gewöhnlich dazu gezwungen, die Hauptlautstärke ("main volume") anzupassen bzw. nachzuregeln, um die gleiche, subjektiv wahrgenommene Lautstärke wie zuvor zu erzielen. Die wahrgenommene Lautstärke, die unter dem Begriff "Lautheit" bekannt ist, ist abhängig von den Frequenzen, Amplituden und der zeitlichen Lage der Audio-Signale.

Gemäß der Online-Enzyklopädie Wikipedia ist die Lautheit eine Größe zur proportionalen Abbildung des menschlichen Lautstärkeempfindens (vgl. http://www.wikipedia.de zum Stichwort "Lautheit", Version vom 3. August 2015).

Lautheit ist ein psychoakustischer Begriff, der beschreibt, wie eine Anzahl von Testpersonen die empfundene Lautstärke überwiegend beurteilt. Die Lautheit hängt vom Schalldruckpegel, dem Frequenzspektrum und dem Zeitverhalten des Schalls ab. Hervorgerufen wird das Lautheitsempfinden von der Art und Weise der Schallverarbeitung im Innenohr. Je nach Stärke der Erregung der Nervenzellen wird ein Geräusch lauter oder leiser beurteilt. Die Lautheit soll sich im Allgemeinen verdoppeln, wenn der Schall als doppelt so laut empfunden wird.

Für die quantitative Bestimmung der Lautheit sind genormte Messverfahren bekannt. Der im Rahmen der vorliegenden Offenbarung benutzte Begriff "Lautheit" soll jedoch allgemein als psychoakustisch gewichtete Lautstärke verstanden werden, die der nach genormten Messverfahren bestimmten Lautheit (gemessen in "Sone") entsprechen kann, jedoch auch mittels alternativer (ggf. vereinfachter) Verfahren bestimmt werden kann.

Es sind Algorithmen bekannt, welche die Lautstärke der Audio-Signale im Wege einer Echtzeitverarbeitung anpassen. Allerdings ändern diese Algorithmen die betreffende Tonspur unter Einsatz von Equalizern, Kompressoren oder Begrenzern, oder sie verringern die Dynamik infolge der Regelung. Darüber hinaus erfordern solche Algorithmen häufig eine hohe Rechen- sowie Speicherkapazität.

Zum Stand der Technik wird lediglich beispielhaft auf WO 2013/154823 A2, WO 2004/111994 A2, EP 1 805 891 B1, EP 1 629 463 A2, EP 1 835 487 A2 und EP 1 763 923 A1 verwiesen.

Die US 2009/0271185 A1 offenbart ein Verfahren zur Verarbeitung von Audio-Signalen in einem Entertainment-System, wobei Audio-Signale wenigstens einer Audioquelle bei Wiedergabe durch das Entertainment-System zur Anpassung an einen psychoakustischen Lautheits-Sollwert modifiziert werden, wobei diese Modifikation jeweils auf folgender Basis erfolgt: Es werden eine Mehrzahl lokaler Lautheitsmaxima jeweils innerhalb eines feststehenden Zeitintervalls ermittelt, und daraus wird ein Regelsignal ermittelt, das die lokalen Lautheitsmaxima, normiert auf den Lautheits-Sollwert, berücksichtigt, die den Lautheits-Sollwert überschreiten, wobei das Regelsignal einer geglätteten Version dieser lokalen Lautheitsmaxima entspricht.

Es ist eine Aufgabe der vorliegenden Erfindung, ein Verfahren und eine Vorrichtung zur Verarbeitung von Audio-Signalen bereitzustellen, wobei mit vergleichsweise geringem Rechen- und Speicheraufwand eine möglichst gute Übereinstimmung der bei den Audio-Signalen unterschiedlicher Audioquellen jeweils subjektiv wahrgenommenen Lautstärke bzw. Lautheit erzielt werden kann.

Diese Aufgabe wird durch das Verfahren gemäß den Merkmalen des unabhängigen Anspruchs 1 bzw. die Vorrichtung gemäß den Merkmalen des Anspruchs 7 gelöst.

Gemäß einer Ausführungsform werden Audio-Signale von wenigstens zwei unterschiedlichen Audioquellen bei Wiedergabe durch das Entertainment-System zur Anpassung an einen psychoakustischen Lautheits-Sollwert modifiziert.

Der Erfindung liegt insbesondere das Konzept zugrunde, eine Echtzeit-Anpassung unterschiedlicher Audioquellen an einen psychoakustischen Lautheits-Sollwert vorzunehmen. Dabei basiert das erfindungsgemäße Verfahren insbesondere auf Echtzeitdaten des Audiostroms, ohne dass eine Kenntnis zukünftiger Werte vorliegen muss. Des Weiteren werden die Audio-Signale einer oder mehrerer Audioquellen jeweils verarbeitet, ohne dass jeweils eine Abhängigkeit von den Audio-Signalen anderer Audioquellen gegeben ist.

Das erfindungsgemäße Verfahren dient nicht etwa zur Lautstärkeanpassung unterschiedlicher Musikstücke bzw. Songs, welche von ein- und derselben Audioquelle abgespielt werden. Vielmehr erfolgt eine dynamische Anpassung der Audio-Signale unterschiedlicher Audioquellen des Entertainmentsystems hinsichtlich der jeweils maximalen, subjektiv wahrgenommenen Lautheit.

Dabei stellt der Begriff "Lautheit", wie eingangs schon erwähnt, eine näherungsweise der psychoakustisch von einem Benutzer empfundenen Lautstärke proportionale Größe dar. Diese Lautheit kann nach den einschlägigen Normen berechnet werden, kann aber auch durch vereinfachte Näherungen bestimmt werden. Insbesondere können die für die Lautheitsbestimmung erforderlichen Frequenzwichtungen an die besonderen Erfordernisse bei Kraftfahrzeugen (z.B. durch Berücksichtigung der typischen Hintergrundgeräuschspektren) angepasst werden.

Gemäß einer Ausführungsform werden bei Modifikation die Audio-Signale jeweils mit einer von der jeweils zugehörigen Audioquelle abhängigen Verstärkung multipliziert.

Gemäß einer Ausführungsform wird diese Verstärkung jeweils als Quotient aus einem Lautheits-Sollwert und dem mittleren psychoakustischen Lautheitsmaximum berechnet.

Die Erfindung betrifft weiter eine Vorrichtung zur Verarbeitung von Audio-Signalen, wobei Audio-Signale wenigstens einer Audioquelle bei der Wiedergabe durch das Entertainment-System zur Anpassung an einen psychoakustischen Lautheits-Sollwert modifizierbar sind, wobei die Vorrichtung dazu konfiguriert ist, ein Verfahren mit den vorstehend beschriebenen Merkmalen durchzuführen. Zu Vorteilen und vorteilhaften Ausgestaltungen der Vorrichtung wird auf die obigen Ausführungen im Zusammenhang mit dem erfindungsgemäßen Verfahren verwiesen.

Der erfindungsgemäße Prozess basiert insbesondere auf einer langfristigen Signalinformation. Dies wird durch eine extreme Datenreduzierung ermöglicht. Da eine Änderung der Verstärkung im Normallfall ohne Speicherüberschreibung nur sehr langsam erfolgt, ist der Hörer bzw. Nutzer des Entertainment-Systems nicht in der Lage, eine dynamische Lautstärke- bzw. Lautheitsänderung wahrzunehmen. Ferner wird hierdurch der Anpassungsprozess sehr stabil und erfordert nur eine vergleichsweise geringe Rechenleistung.

Weitere Ausgestaltungen der Erfindung sind der Beschreibung sowie den Unteransprüchen zu entnehmen.

Die Erfindung wird nachstehend anhand einer bevorzugten Ausführungsform und unter Bezugnahme auf die beigefügten Abbildungen näher erläutert.

Es zeigen:
- Figur 1: ein Diagramm zur Erläuterung des erfindungsgemäßen Verfahrens zur Lautstärkeanpassung;
- Figur 2: ein Flussdiagramm zur Erläuterung einer im Rahmen des erfindungsgemäßen Verfahrens erfolgenden Abschätzung der maximalen Lautheit;
- Figur 3: ein Flussdiagramm zur Erläuterung einer möglichen Implementierung der Lautheitsbestimmung gemäß Schritt S22 aus Figur 2; und
- Figur 4: eine schematische Darstellung der Berechnung der mittleren maximalen Lautheit gemäß Schritt S29 aus Figur 2.

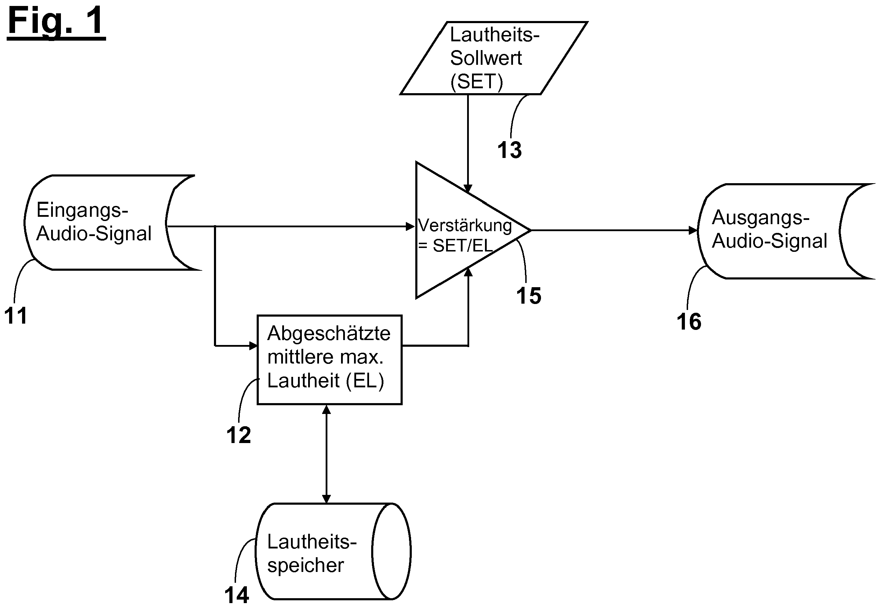

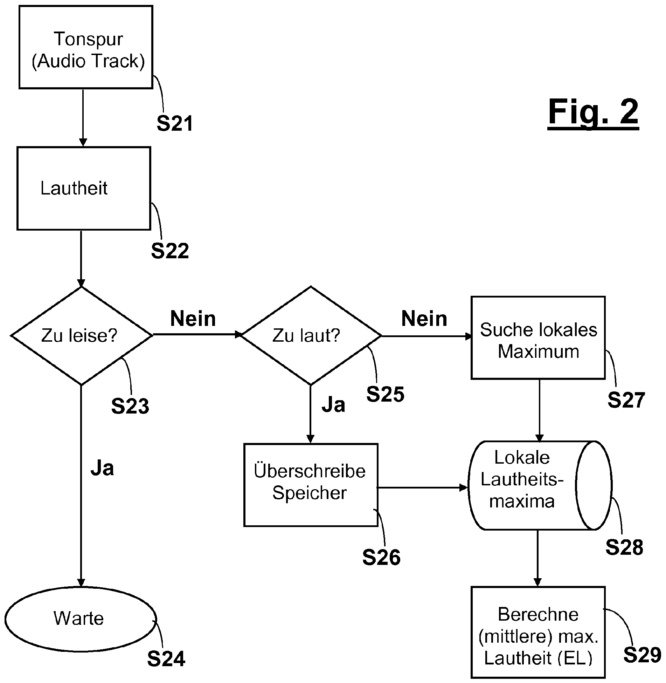

Gemäß Fig. 1 wird bei dem erfindungsgemäßen Verfahren zur Lautstärkeanpassung ein Eingangs-Audio-Signal 11 durch Multiplikation mit einer quellen- und zeitabhängigen Verstärkung 15 modifiziert, um ein Ausgangs-Audio-Signal 16 zu erhalten. Die Verstärkung 15 wird aus einem konstanten Wert berechnet, indem ein Lautstärke-Sollwert (SET) 13 durch die abgeschätzte, mittlere maximale psychoakustische Lautstärke 12 aus einem Lautstärkespeicher 14 (wie im Weiteren unter Bezugnahme auf Fig. 2 noch näher erläutert) dividiert wird. Um eine Signalverzerrung zu vermeiden, welche durch sprunghafte Änderungen der Verstärkung 15 verursacht werden könnte, wird vorzugsweise der Verstärkungswert mit der Zeit allmählich abgeschwächt.

Das erfindungsgemäße Verfahren beinhaltet insbesondere eine Abschätzung des mittleren Maximums der psychoakustischen Lautstärke zwecks Berechnung der Verstärkung, wobei der für diese Abschätzung durchgeführte Prozess im Weiteren unter Bezugnahme auf das Flussdiagramm von Fig. 2 beschrieben wird.

Hierbei wird die abgeschätzte, mittlere maximale Lautheit im Weiteren als EL-Wert (EL = "estimated average maximum loudness") bezeichnet. Die Berechnung des EL-Wertes erfolgt unter Verwendung von aus der Vergangenheit vorliegenden Lautstärkedaten des Audio-Signals der jeweiligen Audioquelle.

Zur Berechnung des EL-Wertes wird zunächst die aktuelle Lautheit in Abhängigkeit von der Signalfrequenz für eine bestimmte Tonspur (Audiotrack) gemessen (Schritte S21 und S22 in Fig. 2). Die so gemessenen Lautheitswerte werden dazu verwendet, ein lokales Maximum innerhalb eines feststehenden Zeitintervalls zu ermitteln. Die jeweils aktuellen Lautheitsmaxima werden in einem Speicher abgespeichert, wobei in diesem Speicher abgelegte Werte gemäß der Abfrage S25 ("Zu laut?") im Schritt S26 jeweils überschrieben werden, wenn der jeweilige bisherige EL-Wert um eine festgelegte Toleranz überschritten wird. Ist die aktuelle Lautheit der Tonspur kleiner als ein vordefinierter Wert, so wird im Schritt S23 ("Zu leise?") die Anpassung pausiert

Die Daten zur Speicherung einer Lautheits-Charakteristik der Tonspur werden jeweils gemäß Schritt S28 auf Basis der Suche nach einem lokalen Maximum innerhalb eines festen Zeitintervalls (Schritt S27) erhalten. Die in dem Speicher vorliegenden Werte beinhalten somit die jeweiligen Lautheitsmaxima des Audio-Signals der betreffenden Audioquelle. Der EL-Wert wird auf Basis der gespeicherten Lautheitsmaxima berechnet (Schritt S29).

Falls keine älteren Lautstärkewerte verfügbar sind (z.B. weil es sich um eine neue, unbekannte Audioquelle handelt) oder falls die aktuelle Lautstärke wesentlich größer als der EL-Wert ist, erfolgt eine schnelle approximative Ermittlung eines neuen EL-Wertes. Diese Approximation basiert auf den neuen Lautheitsmaxima der ankommenden Tonspur bzw. des Audio-Tracks. Sobald ein neues mittleres Maximum gefunden ist, wird der Speicherinhalt mit diesem Wert überschrieben, und die erfindungsgemäße Berechnung wird erneut durchgeführt.

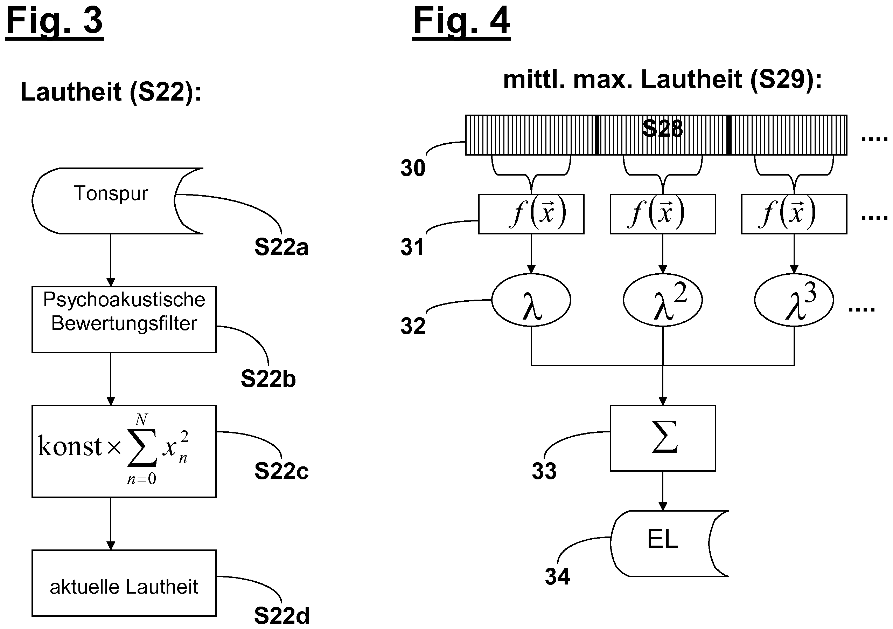

In Fig. 3 wird ein beispielhafter, schematischer Algorithmus für eine Lautheitsbestimmung in Schritt S22 von Fig. 2 dargestellt. Die Tonspur (S22a) wird in einzelne Frequenzanteile (z.B. durch eine Fourier-Analyse) zerlegt. Auf dieses diskrete Spektrum wird in Schritt S22b ein psychoakustischer Bewertungsfilter, z.B. ein Bandpass, angewandt, der z.B. die Form einer nach unten offenen Parabel mit einem Maximum bei dem Wahrnehmungsmaximum des menschlichen Ohrs haben kann. Das Quadrat der so gewonnen gewichteten Spektralanteile wird in Schritt S22c aufaddiert und ergibt multipliziert mit einer Normierungskonstante einen Wert, der für die aktuelle Lautheit repräsentativ sein kann (S22d). Neben der in Fig. 3 dargestellten Lautheitsbestimmung sind auch vielfältige andere Algorithmen zur Lautheitsbestimmung denkbar.

In Fig. 4 wird ein Verfahren zur Bestimmung der mittleren maximalen Lautheit, wie sie in Schritt S29 von Fig. 2 verwendet wird, dargestellt. Dabei werden die im Speicher vorliegenden Lautheitsmaxima bei 30 in einzelne Blöcke (hier drei) unterteilt. Auf die einzelnen Abschnitte wird bei 31 eine Funktion *f*(*̅x̅*̅) angewendet, die einen maximumnahen Wert liefert, beispielsweise max(*̅x̅*̅) und/oder *mean*(*̅x̅*̅) + *std*(*̅x̅*̅) und/oder *mean*(*̅y̅*̅)*,* wobei *̅y̅*̅ alle Werte, für die gilt *xᵢ* > *mean*(*̅x̅*̅) bedeuten soll (mean = Mittelwert, max = Maximum und std = Standardabweichung). Bei 32 kann auf die einzelnen maximumnahen Werte optional ein sog. Vergessensfaktor *λ* angewandt werden, wobei 0 < *λ* < 1. Hierdurch werden die zeitlich weiter zurück liegenden Werte geringer gewichtet als die zeitlich nahe liegenden. Schließlich werden die so gewonnen Werte bei 33 zu einer Summe addiert (ggf. nach vorheriger Quadrierung) und so bei 34 der Wert EL gewonnen.

## Patentansprüche

1. Verfahren zur Verarbeitung von Audiosignalen in einem Entertainment-System, wobei Audio-Signale wenigstens einer Audioquelle bei Wiedergabe durch das Entertainment-System zur Anpassung an einen psychoakustischen Lautheits-Sollwert modifiziert werden, wobei diese Modifikation jeweils auf Basis eines für die betreffende Audioquelle über ein vorgegebenes Zeitintervall ermittelten mittleren psychoakustischen Lautheitsmaximums EL erfolgt, wobei zur Ermittlung des Wertes EL die aktuelle Lautheit in Abhängigkeit von der Signalfrequenz für eine bestimmte Tonspur gemessen wird (S22), die so gemessenen Lautheitswerte dazu verwendet werden, ein lokales Maximum innerhalb eines feststehenden Zeitintervalls zu ermitteln (S27), und die jeweils aktuellen Lautheitsmaxima in einem Speicher abgespeichert werden (S28), so dass die in dem Speicher vorliegenden Werte die jeweiligen Lautheitsmaxima des Audiosignals der Tonspur beinhalten, und der Wert EL auf Basis der gespeicherten Lautheitsmaxima berechnet wird (S29), indem die im Speicher vorliegenden Werte in einzelne Blöcke unterteilt werden (30) und auf die einzelnen Abschnitte eine Funktion angewendet wird, die einen maximumnahen Wert liefert (31), und die so über das vorgegebene Zeitintervall gewonnen Werte zu einer Summe, ggf. nach vorheriger Quadrierung, addiert werden (33), um so den Wert EL zu gewinnen (34).

2. Verfahren nach Anspruch 1,
**dadurch gekennzeichnet, dass**
Audio-Signale von wenigstens zwei unterschiedlichen Audioquellen bei Wiedergabe durch das Entertainment-System zur Anpassung an einen psychoakustischen Lautheits-Sollwert modifiziert werden.

3. Verfahren nach Anspruch 1 oder 2,
**dadurch gekennzeichnet, dass**
bei dieser Modifikation die Audio-Signale (11) jeweils mit einer von der zugehörigen Audioquelle abhängigen Verstärkung (15) multipliziert werden.

4. Verfahren nach Anspruch 3,
**dadurch gekennzeichnet, dass**
diese Verstärkung (15) jeweils als Quotient aus einem Lautheits-Sollwert (13) und dem mittleren psychoakustischen Lautheitsmaximum (EL) berechnet wird.

5. Verfahren nach einem der vorhergehenden Ansprüche,
**dadurch gekennzeichnet, dass**
die Modifikation der Audio-Signale (11) jeweils auf Basis von Echtzeitdaten eines Audio-Signal-Datenstroms durchgeführt wird.

6. Verfahren nach einem der vorhergehenden Ansprüche,
**dadurch gekennzeichnet, dass**
bei der Modifikation Audio-Signale (11) von einer Audioquelle jeweils unabhängig von Audio-Signalen einer anderen Audioquelle verarbeitet werden.

7. Vorrichtung zur Verarbeitung von Audio-Signalen, **dadurch gekennzeichnet, dass**
Audio-Signale wenigstens einer Audioquelle bei der Wiedergabe durch das Entertainment-System zur Anpassung an einen psychoakustischen Lautheits-Sollwert modifizierbar sind, wobei die Vorrichtung dazu konfiguriert ist, ein Verfahren nach einem der vorhergehenden Ansprüche durchzuführen.

## Claims

1. Method for processing audio signals in an entertainment system, wherein audio signals from at least one audio source are modified during playback by the entertainment system for adjustment to a psychoacoustic loudness set value, wherein this modification is performed in each case on the basis of an average psychoacoustic loudness maximum EL determined over a predefined time interval for the audio source concerned, wherein, in order to determine the value EL, the current loudness is measured (S22) depending on the signal frequency for a specific audio track, the loudness values measured in this way are used to determine (S27) a local maximum within a fixed time interval, and the respective current loudness maxima are stored (S28) in a memory, with the result that the values present in the memory contain the respective loudness maxima of the audio signal of the sound track, and the value EL is calculated (S29) on the basis of the stored loudness maxima by subdividing (30) the values present in the memory into individual blocks and applying a function to the individual sections, which function provides (31) a value close to the maximum, and adding (33) the values obtained in this way over the predefined time interval to form a sum, if necessary following prior squaring, in order to thus obtain (34) the value EL.

2. Method according to Claim 1,
**characterized in that**
audio signals from at least two different audio sources are modified during playback by the entertainment system for adjustment to a psychoacoustic loudness set value.

3. Method according to Claim 1 or 2,
**characterized in that**
the audio signals (11) are multiplied during this modification in each case by an amplification (15) depending on the associated audio source.

4. Method according to Claim 3,
**characterized in that**
this amplification (15) is calculated in each case as the quotient of a loudness set value (13) and the average psychoacoustic loudness maximum (EL).

5. Method according to one of the preceding claims,
**characterized in that**
the modification of the audio signals (11) is performed in each case on the basis of real-time data of an audio signal data stream.

6. Method according to one of the preceding claims,
**characterized in that**
audio signals (11) from one audio source are processed during the modification in each case independently from audio signals from a different audio source.

7. Apparatus for processing audio signals,
**characterized in that**
audio signals from at least one audio source are modifiable during the playback by the entertainment system for adjustment to a psychoacoustic loudness set value, wherein the apparatus is configured to carry out a method according to one of the preceding claims.

## Revendications

1. Procédé de traitement de signaux audio dans un système d'infodivertissement, les signaux audio d'au moins une source audio étant modifiés lors de la reproduction par le système d'infodivertissement en vue de l'adaptation à une valeur de consigne de volume sonore psychoacoustique, cette modification s'effectuant respectivement sur la base d'un maximum de volume sonore psychoacoustique moyen EL déterminé sur un intervalle de temps prédéfini pour la source audio concernée, la valeur EL étant déterminée en mesurant le volume sonore actuel en fonction de la fréquence de signal pour une piste sonore déterminée (S22),
les valeurs du volume sonore ainsi mesurées étant utilisées pour déterminer un maximum local au sein d'un intervalle de temps fixe (S27),
et les maxima de volume sonore actuels respectifs étant enregistrés dans une mémoire (S28),
de sorte que les valeurs présentes dans la mémoire contiennent les maxima de volume sonore respectifs de la piste sonore, et la valeur EL étant calculée sur la base des maxima de volume sonore enregistrés (S29),
en subdivisant les valeurs présentes dans la mémoire en blocs individuels (30),
et en appliquant sur les portions individuelles une fonction qui délivre une valeur proche du maximum (31),
et les valeurs ainsi obtenues sur l'intervalle de temps prédéfini étant additionnées en une somme, le cas échéant après une élévation au carré préalable (33) afin d'obtenir ainsi la valeur EL (34).

2. Procédé selon la revendication 1, **caractérisé en ce que** les signaux audio d'au moins deux sources audio différentes sont modifiés lors de la reproduction par le système d'infodivertissement en vue de l'adaptation à une valeur de consigne de volume sonore psychoacoustique.

3. Procédé selon la revendication 1 ou 2, **caractérisé en ce que** lors de cette modification, les signaux audio (11) sont respectivement multipliés par un gain (15) dépendant de la source audio associée.

4. Procédé selon la revendication 3, **caractérisé en ce que** ce gain (15) est respectivement calculé en tant que quotient d'une valeur de consigne de volume sonore (13) et du maximum de volume sonore psychoacoustique moyen (EL).

5. Procédé selon l'une des revendications précédentes, **caractérisé en ce que** la modification des signaux audio (11) est respectivement réalisée sur la base de données en temps réel du flux de données de signal audio.

6. Procédé selon l'une des revendications précédentes, **caractérisé en ce que** lors de la modification, les signaux audio (11) d'une source audio sont respectivement traités indépendamment des signaux audio d'une autre source audio.

7. Dispositif de traitement de signaux audio, **caractérisé en ce que** les signaux audio d'au moins une source audio peuvent être modifiés lors de la reproduction par le système d'infodivertissement en vue de l'adaptation à une valeur de consigne de volume sonore psychoacoustique, le dispositif étant configuré pour mettre en œuvre un procédé selon l'une des revendications précédentes.
